# EUROPEAN PATENT APPLICATION

(11) **EP 4 826 924 A1**
(43) Date of publication of application: **21.10.2026**
(21) Application number: 25170283.3
(22) Date of filing: 14.04.2025
(51) Int. Cl.: H01S 3/00, H01S 3/23, H01S 5/065

(54) **LIGHT-GENERATING APPARATUS FOR A MICROSCOPE**

(71) Applicant: Leica Microsystems CMS GmbH, 35578 Wetzlar (DE)
(72) Inventor: Dyba, Marcus, 35578 Wetzlar (DE)
(74) Representative: Schaumburg und Partner Patentanwälte mbB

(57) **Abstract**

A light-generating apparatus (204) for a microscope (202) comprises a first laser unit (206) having a fiber arrangement (220) of optical fibers (212, 216, 218) including a nonlinear optical fiber (218) configured to generate super-continuum laser light, and at least one second laser unit (208) configured to generate additional laser light which is spectrally outside the super-continuum laser light. The second laser unit (208) comprises an optical connection fiber (222) connected to one of the optical fibers (212, 216, 218) of the fiber arrangement (220) of the first laser unit (206) to spatially combine the additional laser light with the super-continuum laser light.

## Description

### Technical field

The invention relates to a light-generating apparatus and a microscope system comprising such a light-generating apparatus.

### Background

Super-continuum laser sources, also known as white-light laser sources (WLLs), are widely used in laser scanning microscopy. These laser sources initially generate high-power, pulsed laser light with a wavelength in the near infrared (NIR). The pulsed NIR laser light is then coupled into a nonlinear optical fiber where nonlinear optical effects cause significant spectral broadening. As a result, initially narrowband laser pulses transform into a continuous broadband spectrum, covering a wide wavelength range from NIR to the turquoise or blue spectrum.

While high-end super-continuum laser sources can reach wavelengths as short as 440 nm, providing even shorter wavelengths remains a challenge. Generating shorter wavelengths via super-continuum processes would require higher pump power, which, in turn, accelerates the degradation of the nonlinear optical fibers and ultimately shortens the lifespan of the laser source. However, from an application standpoint, shorter wavelengths are highly sought after in modern laser scanning microscopy, making their development a key focus in the field.

According to a conventional approach, a spectral gap between application requirements and available super-continuum laser technology is closed by adding a further e.g. solid-state laser source which provides a desired, typically shorter wavelength. Thus, the additional laser source is integrated, in free space, either directly into the microscope or into a common light guide that leads to the microscope.

However, this approach has the disadvantage of higher costs and increased instability due to the additional optical elements required for free-space beam routing.

### Summary

It is an object to provide a light-generating apparatus for a microscope system, which is capable of providing laser light in a wide wavelength range while having a compact design and a long lifespan.

The afore-mentioned object is achieved by the subject-matter of the independent claim. Further embodiments are defined in the dependent claims and the following description.

The light-generating apparatus comprises a first laser unit having a fiber arrangement of optical fibers including a nonlinear optical fiber configured to generate super-continuum laser light. The light-generating apparatus further comprises at least one second laser unit configured to generate additional laser light which is spectrally outside the super-continuum laser light. The second laser unit comprises an optical connection fiber connected to one of the optical fibers of the fiber arrangement of the first laser unit to spatially combine the additional laser light with the super-continuum laser light.

Compared to conventional approaches that aim to extend the wavelength range of a white-light laser source itself by influencing super-continuum processes in the nonlinear optical fiber, which requires higher pump power and thus results in a higher risk of fiber degradation, the proposed solution avoids fiber degradation by leaving the first laser unit essentially unchanged. Instead, the additional second laser unit is used to extend the wavelength range beyond the spectral capacity of the first laser unit. Furthermore, by using the optical connection fiber, the light-generating apparatus requires essentially no free-space propagation to combine the laser light emitted by the second laser unit with the super-continuum light emitted by the first laser unit. This results in a compact design of the laser generation apparatus as there is no need for dedicated optical elements to implement free-space beam routing. Herein, a free-space propagation refers to a laser beam that travels through open space guided by optical elements such as lenses or mirrors rather than to a laser beam that is confined within an optical fiber or the like. In particular, the fact that there is usually a small gap between a laser unit and an optical fiber, when a laser beam is coupled directly into the optical fiber, is not yet to be understood as free-space propagation in the sense of the present disclosure.

According to an embodiment, the nonlinear optical fiber is formed of a photonic crystal fiber. A photonic crystal fiber contains a periodic microstructure, e.g. an array of air holes which enables tailored dispersion properties and high optical nonlinearity. Another embodiment of a nonlinear optical fiber that can be used in the proposed light-generating apparatus is e.g. a tapered fiber having a strongly reduced core diameter to increase power density and to enhance nonlinearity, or a specially designed glass fiber e.g. doped with a material such as germanium.

Typically, the additional laser light generated by the second laser unit is unrelated to the generation of the super-continuum laser light. This means that the combination of the super-continuum laser light generated by the first laser unit and the additional laser light generated by the second laser unit is to be understood as a pure spatial superposition of light of different spectral components, without these different spectral components interacting with each other to induce specific optical effects such as pumping that might significantly influence the generation of the super-continuum laser light.

According to an embodiment, the first laser unit comprises a seed laser having an optical seed fiber configured to transmit seed laser light, and a pump laser having an optical pump fiber configured to transmit pump laser light. The fiber arrangement of the first laser unit may comprise the optical seed fiber, the optical pump fiber, and the nonlinear optical fiber. The nonlinear optical fiber may be directly or indirectly coupled to the optical seed fiber and/or the optical pump fiber to generate the super-continuum laser light based on the seed laser light and the pump laser light.

The seed laser may be formed of a pulsed laser with relatively low light emission power. The laser pulses emitted from the seed laser are in the NIR range, typically at 1064 nm. The pump laser may be a continuous wave (CW) laser which pumps the optical seed fiber or the optical pump fiber, resulting in an amplification of the low-power pulses emitted by the seed laser. The amplified NIR laser pulses then enter the nonlinear optical fiber, where the super-continuum laser light is generated by nonlinear optical effects.

According to an embodiment, the optical connection fiber of the second laser unit is connected to one of the optical seed fiber, the optical pump fiber or the nonlinear optical fiber. Since the additional laser light emitted by the second laser unit is essentially not related to the process of generating the super-continuum laser light emitted by the first laser unit, it is possible to choose one of the optical fibers contained in the first laser unit to which the optical connection fiber is to be connected to combine the additional light with the super-continuum light.

The fiber arrangement of the first laser unit may comprise an optical output fiber connected to an output end of the nonlinear optical fiber. The optical connection fiber of the second laser unit may be connected to the optical output fiber. Instead of connecting the nonlinear optical fiber directly to a microscope, using the optical output fiber for coupling the light-generating apparatus to the microscope offers advantages in terms of flexibility.

According to an embodiment, the optical connection fiber of the second laser unit is coupled to the fiber arrangement of the first laser unit through a spliced optical fiber connection. Fusion splicing or mechanical splicing may be used to provide for the optical fiber connection. In fusion splicing, fiber ends are precisely aligned and fused together using an electrical arc. Mechanical splicing involves aligning and holding the fiber ends together using a fiber merging module. Mechanical splicing may be preferable because it is less expensive than fusion splicing and results in a slightly higher, but still tolerable insertion loss.

The second laser unit may be formed of a monolithic laser module with its optical connection fiber permanently attached. Such a monolithic laser module having an optical fiber permanently attached to its output is also referred to as a pig-tailed laser. The permanently attached optical connection fiber helps to guide the emitted laser light, improves beam stability, and makes it easy to integrate the second laser unit into the light-generating apparatus. Further, using such a pig-tailed laser that is directly spliced to the fiber arrangement of the first laser unit is a cost-efficient and stable option in terms of beam pointing, laser noise, power drift, and power fluctuations.

According to an embodiment, the light-generating apparatus comprises a single housing in which the first laser unit and the second laser unit are jointly accommodated. The arrangement of the components of the light-generating apparatus in a single housing ensures a compact design and in particular power supply or cooling elements might be shared by the light-generating apparatus, the first laser unit and/or the second laser unit.

The second laser unit may be configured to generate the additional laser light with at least one single wavelength. As an example of a use case, it may be assumed that the super-continuum spectrum from the first laser unit is limited to wavelengths between 440 nm and 800 nm and additional laser light at a wavelength of 405 nm is required for a specific application. In this case, using the second laser unit, the additional wavelength of 405 nm can easily be combined with the super-continuum spectrum. As a further example it may be assumed that the above-mentioned super-continuum only extends to a shortest wavelength of 480 nm, but both wavelengths of 405 nm and 440 nm are needed for an application. In this case, two additional and separate units in the form of the second laser units may be provided, delivering the additional wavelengths of 440 nm and 405 nm, respectively. Furthermore, it is also possible to provide only one additional laser unit which adds two discrete wavelengths to the super-continuum spectrum.

It goes without saying that this concept can be extended to more than two additional wavelengths. Furthermore, the additional laser light, which lies spectrally outside the super-continuum laser light, can also be provided as a continuous wavelength range instead of one or more individual wavelengths. Accordingly, the at least one second laser unit may either comprise one or more line lasers or a laser configured to emit the additional laser light as a continuous spectrum.

The second laser unit may be configured to generate the additional laser light having a wavelength smaller than a minimum wavelength of the super-continuum laser light. For example, the additional wavelength may be smaller than 470nm or even smaller than 410 nm. As mentioned above, in a conventional approach to enhance the spectral capacity of the white-light laser source itself for extending the super-continuum spectrum by one or more particularly short wavelengths, high pump power is required. This might result in a significant degradation of the nonlinear optical fiber. The present embodiment reliably avoids fiber degradation by preventing excessively high pump powers.

The second laser unit may comprise a solid-state laser, in particular a diode laser which allows for a compact design.

The second laser unit may comprise a pulsed laser. Using a pulsed laser allows to synchronize the additional laser light with the super-continuum laser light, which is also pulsed light. For example, pulse synchronization can be performed such that the pulses emitted from the first and second laser units do not spatially overlap when propagating in the nonlinear optical fiber, thus avoiding adverse effects on the generation of the super-continuum laser light. For other applications, however, such as those requiring constant light output, it may be advantageous for the second laser unit to include a CW laser that emits the additional laser light which is spectrally outside the super-continuum laser light in the form of a continuous laser beam.

According to an embodiment, the second laser unit is configured to control the power of the additional laser light separately from the power of the super-continuum laser light. Individual control of the output power of the various laser units increases the flexibility with which light can be applied to a sample.

There might be means provided which prevent distortion of e.g. the activity of the seed laser by light from the second laser, such as an optical isolator or the like.

According to another aspect, a microscope system is provided which comprises a light-generating apparatus as described above. In particular, the microscope system may comprise a laser scanning microscope in which the laser light emitted by the light-generating apparatus is used for fluorescence imaging.

### Short Description of the Figures

Hereinafter, embodiments are described referring to the drawings, wherein:
- Figure 1: is a schematic diagram showing a microscope system including a light-generating apparatus as a comparative example;
- Figure 2: is a schematic diagram showing a microscope system including a light-generating apparatus according to an embodiment;
- Figure 3: is a schematic diagram showing the microscope system including an alternative embodiment of the light-generating apparatus; and
- Figure 4: is a schematic diagram showing the microscope system including another alternative embodiment of the light-generating apparatus.

### Detailed Description of the Figures

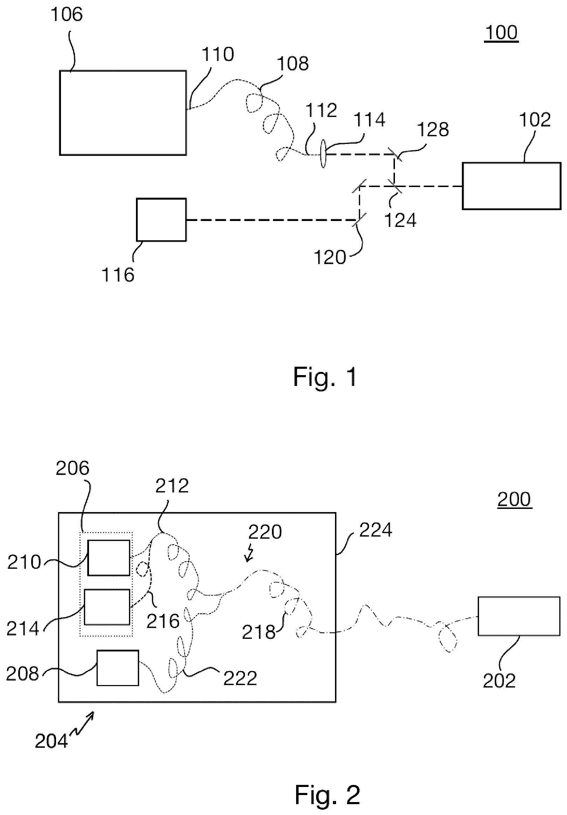

Figure 1 shows a microscope system 100 in accordance with a comparative example that uses a conventional approach to extend a spectrum of super-continuum laser light.

The microscope system 100 of Figure 1 includes a microscope 102 and a light-generating apparatus 104 optically coupled to the microscope 102. It should be noted that Figure 1 shows only those components of the microscope system 100 that contribute to an understanding of the present disclosure. In particular, the microscope system 100 may include additional components not shown in Figure 1. The same applies to the embodiments shown in Figures 2 to 4.

The light-generating apparatus 102 comprises a white-light laser source 106 configured to emit super-continuum laser light. For example, the super-continuum laser light emitted from the white-light laser source 106 is assumed to be in the range of 440 nm to 800 nm. The super-continuum laser light is transmitted through an optical fiber 108. One end 110 of the optical fiber 108 is connected to the white-light laser source 106. An opposite end 112 of the optical fiber 108 faces a lens 114 through which the super-continuum laser light enters a free space, i.e. a space not confined by an optical fiber or the like.

The light-generating apparatus 104 comprises an additional laser source 116 which is configured to emit monochromatic laser light of a specific wavelength which is outside the spectrum of the super-continuum laser light. In the comparative example, it is assumed that the wavelength of the laser light emitted by the additional laser source 116 is shorter than the lower limit of the super-continuum spectrum. For example, the additional wavelength may be assumed to be 405 nm.

Like the super-continuum light, the laser light of 405 nm is emitted into free space. In order to combine the super-continuum laser light with the monochromatic laser light, a dedicated optical system is arranged in the free space, including mirrors 118, 120, 122 and a dichroic mirror 124. The mirrors 118, 120 and 122 reflect the super-continuum laser light and the monochromatic laser light onto the dichroic mirror 124 which is spectrally designed to combine both laser beams by reflection and transmission, respectively. Using such free-space beam routing, the super-continuum laser light and the monochromatic laser light enter the microscope 102 along a common beam path.

The free-space beam routing illustrated in Figure 1 has the disadvantage that the optical elements 118 to 124 are required to guide the laser beams to the microscope 102. The provision of the optical elements 118 to 124 is costly and their adjustment is cumbersome.

Figure 2 shows a microscope system 200 according to an embodiment that is configured to avoid the problems addressed above with respect to the comparative example of Figure 1.

The microscope system 200 comprises a microscope 202, e.g. a laser scanning microscope, and a light-generating apparatus 204 optically coupled to the microscope 202. The light-generating apparatus 204 includes a first laser unit 206 and at least one second laser unit 208. The first laser unit 206 forms a white-light laser source, while the second laser unit 208 comprises a monochromatic laser source. As in the comparative example of Figure 1, the white-light laser source formed of the first laser unit 206 may be configured to generate super-continuum laser light in a predetermined wavelength range, e.g. from 440 nm to 800 nm, and the monochromatic laser source formed of the second laser unit 208 may be configured to generate monochromatic laser light of a specific wavelength such as 405 nm.

The first laser unit 206 comprises a seed laser 210 having an optical seed fiber 212 which is configured to transmit seed laser light emitted from the seed laser 210. The seed laser 210 may be formed of a pulsed laser which outputs the seed light in the form of low-power NIR laser pulses into a laser cavity which may comprise a fiber, preferably a Yb pump fiber (not shown), constituting the laser medium.

The first laser unit 206 further comprises a pump laser 214 having an optical pump fiber 216 which is configured to transmit pump laser light emitted from the pump laser 214. The pump laser 214 may be formed of a CW laser which outputs the pump light with high power.

In the embodiment shown in Figure 2, the optical pump fiber 216 is connected to the optical seed fiber 212. The pump laser 214 is configured to pump the optical seed fiber 212 through the optical pump fiber 216 with the high-power pump light which amplifies the pulsed seed laser light.

The first laser unit 206 further includes a nonlinear optical fiber 218 which is connected to an output end of the optical seed fiber 212. The nonlinear optical fiber 218 is configured to generate super-continuum laser light. For this purpose, the nonlinear optical fiber 218 may be formed e.g. of a photonic crystal fiber having a periodic microstructure that is capable of creating super-continuum laser light taking advantage of nonlinear optical effects.

The first laser unit 206 comprises a fiber arrangement 220 which includes the nonlinear optical fiber 218. In the specific embodiment shown in Figure 2, the fiber arrangement 220 further includes the optical seed fiber 212 and the optical pump fiber 216. The optical fibers 212, 216, 218 of the fiber arrangement 220 are interconnected e.g. by spliced optical fiber connections.

The second laser unit 208 comprises an optical connection fiber 222 which is coupled to one of the optical fibers 212, 216, 218 of the fiber arrangement 220 of the first laser unit 206. In the embodiment shown in Figure 2, the optical connection fiber 222 of the second laser unit 208 is directly spliced to the nonlinear optical fiber 218. The optical connection to the nonlinear optical fiber 218 serves to spatially (and optically) combine the additional monochromatic laser light generated by the second laser unit 208 with the super-continuum laser light generated by the first laser unit 206. Accordingly, these two spectral components are jointly transmitted through the nonlinear optical fiber 218. According to the embodiment shown in Figure 2, the nonlinear optical fiber 218 is coupled to the microscope 202 so that the combined laser light is output directly from the nonlinear optical fiber 218 to the microscope 202.

The second laser unit 208 may be a solid-state laser, in particular a diode laser in the form of a pig-tailed laser to which the optical connection fiber 222 is permanently fixed. Such a configuration facilitates the integration of the second laser unit 208 into the light-generating apparatus 204.

The light-generating apparatus 204 may further comprise a single housing 224 which is configured to jointly accommodate the first and second laser units 206 and 208, which results in a compact design. In the configuration of Figure 2, the nonlinear optical fiber 218, which is routed out of the housing 224, forms the output of light-generating apparatus 204.

The light-generating apparatus 204 may further include a controller (not shown in the Figures) which can be used to adjust the power of the additional monochromatic laser light emitted by the second laser unit 208 separately from the power of the super-continuum laser light emitted by the first laser unit 206. In this way, the combined laser output of the light-generating apparatus 204 can be flexibly controlled in relation to various spectral laser light components.

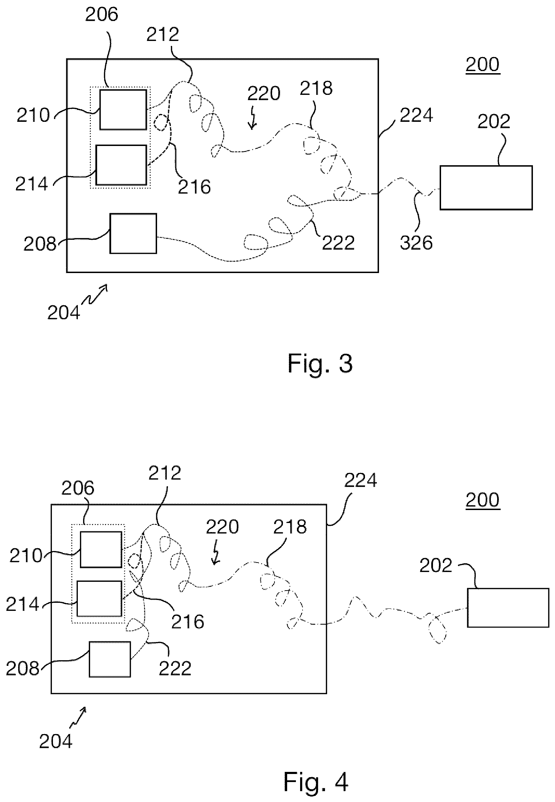

Figures 3 and 4 show alternative embodiments of the light-generating apparatus 204. Hereinafter, only those features are described in which these modified embodiments differ from the configuration shown in Figure 2, and components corresponding to those shown in Figure 2 are denoted with the same reference signs.

In the embodiment shown in Figure 3, the light-generating apparatus 204 comprises an optical output fiber 326 which is routed out of the housing 224 and connected to the microscope 202. Within the housing 224, the optical output fiber 326 is connected to an output end of the nonlinear optical fiber 218. Further, the optical connection fiber 222 of the second laser unit 208 is connected to the optical output fiber 326, in order to combine the additional monochromatic laser light generated by the second laser unit 208 with the super-continuum laser light generated by the first laser unit 206. Again, the fiber connections mentioned above may be implemented by splicing.

According to the embodiment in Figure 3, it is thus the optical output fiber 326 which forms the output of the light-generating apparatus 204, and not, as in the configuration shown in Figure 2, the nonlinear optical fiber 218. The optical output fiber 326 forms a common delivery fiber with respect to the different spectral components which are emitted by the first and second laser units 206 and 208, respectively, and then combined within the housing 224. For this, the optical connection fiber 222 of the second laser unit 208 is directly connected to the optical output fiber 326 rather than to the nonlinear fiber 218.

Figure 4 shows an alternative in which the optical connection fiber 222 of the second laser unit 208 is directly connected, e.g. by splicing, to the optical seed fiber 212 of the first laser unit 206 and not, as in the configuration shown in Figure 2, to the nonlinear optical fiber 218.

The above modifications with respect to the fiber connection between the first and second laser units 206, 208 can be implemented in a flexible manner, since the monochromatic laser light generated by the second laser unit 208 is only spatially combined with the laser light generated by the first laser unit 206, without influencing the super-continuum generation as such. In other words, the additional laser light can be coupled into the optical fiber arrangement 220 at any point within the housing 224.

The embodiments described above should be understood only as non-limiting examples. Thus, according to the embodiments shown in Figures 2 to 4, the additional laser light generated by the second laser unit 208 is monochromatic. However, the second laser unit 208 may also be configured to add a continuous wavelength range to the super-continuum spectrum provided by the first laser unit 206. Further, according to the above embodiments, only one additional laser unit is provided to extend the wavelength spectrum. However, depending on the specific application, the laser generating apparatus may also include more than one laser unit in addition to the first laser unit that provides the super-continuum spectrum.

Identical or similarly acting elements are designated with the same reference signs in all Figures. As used herein the term "and/or" includes any and all combinations of one or more of the associated listed items and may be abbreviated as "/".

Although some aspects have been described in the context of an apparatus, it is clear that these aspects also represent a description of the corresponding method, where a block or device corresponds to a method step or a feature of a method step. Analogously, aspects described in the context of a method step also represent a description of a corresponding block or item or feature of a corresponding apparatus.

### Reference signs

- 100: microscope system
- 102: microscope
- 104: light-generating apparatus
- 106: white-light laser source
- 108: optical fiber
- 110, 112: end of optical fiber
- 112: illumination device
- 114: lens
- 116: additional laser source
- 118, 120, 122: mirror
- 124: dichroic mirror
- 200: microscope system
- 202: microscope
- 204: light-generating apparatus
- 206: first laser unit
- 208: second laser unit
- 210: seed laser
- 212: optical seed fiber
- 214: pump laser
- 216: optical pump fiber
- 218: nonlinear optical fiber
- 220: fiber arrangement
- 222: optical connection fiber
- 224: housing
- 326: optical output fiber

## Claims

1. A light-generating apparatus (204) for a microscope (202), comprising:
a first laser unit (206) comprising a fiber arrangement (220) of optical fibers (212, 216, 218) including a nonlinear optical fiber (218) configured to generate super-continuum laser light, and
at least one second laser unit (208) configured to generate additional laser light which is spectrally outside the super-continuum laser light,
wherein the second laser unit (208) comprises an optical connection fiber (222) connected to one of the optical fibers (212, 216, 218) of the fiber arrangement (220) of the first laser unit (206) to spatially combine the additional laser light with the super-continuum laser light.

2. The light-generating apparatus (204) according to claim 1, wherein the additional laser light is unrelated to the generation of the super-continuum laser light.

3. The light-generating apparatus (204) according to claim 1 or 2, wherein the first laser unit (206) comprises a seed laser (210) having an optical seed fiber (212) configured to transmit seed laser light, and a pump laser (214) having an optical pump fiber (216) configured to transmit pump laser light,
wherein the fiber arrangement (220) of the first laser unit (206) comprises the optical seed fiber (212), the optical pump fiber (216) and the nonlinear optical fiber (218), and
wherein the nonlinear optical fiber (218) is directly or indirectly coupled to the optical seed fiber (212) and the optical pump fiber (216) to generate the super-continuum laser light based on the seed laser light and the pump laser light.

4. The light-generating apparatus (204) according to claim 3, wherein the optical connection fiber (222) of the second laser unit (208) is connected to one of the optical seed fiber (212), the optical pump fiber (216) or the nonlinear optical fiber (218).

5. The light-generating apparatus (204) according to claim 4, wherein the fiber arrangement (220) of the first laser unit (206) comprises an optical output fiber (326) connected to an output end of the nonlinear optical fiber (218), and
wherein the optical connection fiber (222) of the second laser unit (208) is connected to the optical output fiber (326).

6. The light-generating apparatus (204) according to any one of the preceding claims, wherein the optical connection fiber (222) of the second laser unit (208) is coupled to the fiber arrangement (220) of the first laser unit (206) through a spliced optical fiber connection.

7. The light-generating apparatus (204) according to any one of the preceding claims, wherein the second laser unit (208) is formed of a monolithic laser module with its optical connection fiber firmly attached.

8. The light-generating apparatus (204) according to any one of the preceding claims, comprising a single housing (224) in which the first laser unit (206) and the second laser unit (208) are jointly accommodated.

9. The light-generating apparatus (204) according to any one of the preceding claims, wherein the second laser unit (208) is configured to generate the additional laser light with a single wavelength.

10. The light-generating apparatus (204) according to any one of the preceding claims, wherein the second laser unit (208) is configured to generate the additional laser light having a wavelength smaller than a minimum wavelength of the super-continuum laser light.

11. The light-generating apparatus (204) according to any one of the preceding claims, wherein the second laser unit (208) comprises is a diode laser.

12. The light-generating apparatus (204) according to any one of the preceding claims, wherein the second laser unit (208) comprises a pulsed laser.

13. The light-generating apparatus (204) according to any one of the preceding claims, wherein the second laser unit (208) is configured to control the power of the additional laser light separately from the power of the super-continuum laser light.

14. The light-generating apparatus (204) according to any one of the preceding claims, wherein the nonlinear optical fiber (218) is a photonic crystal fiber.

15. A microscope system (200) comprising a light-generating apparatus (204) according to any one of the preceding claims.
